(19) Europäisches Patentamt / European Patent Office / Office européen des brevets

(11) **EP 1 828 712 B1**

(12) **FASCICULE DE BREVET EUROPEEN**

(45) Date de publication et mention
de la délivrance du brevet:
**23.07.2008 Bulletin 2008/30**

(51) Int Cl.:
***G01B 11/06*** *(2006.01)* ***G01J 4/00*** *(2006.01)*
***G01N 21/21*** *(2006.01)*

(21) Numéro de dépôt: **05848201.9**

(22) Date de dépôt: **22.12.2005**

(86) Numéro de dépôt international:
**PCT/FR2005/051130**

(87) Numéro de publication internationale:
**WO 2006/070161 (06.07.2006 Gazette 2006/27)**

(54) **CARACTERISATION METROLOGIQUE DE CIRCUITS DE MICROELECTRONIQUE**

METROLOGISCHE CHARAKTERISIERUNG MIKROELEKTRONISCHER SCHALTUNGEN

METROLOGICAL CHARACTERIZATION OF MICROELECTRONIC CIRCUITS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **24.12.2004 FR 0453231**

(43) Date de publication de la demande:
**05.09.2007 Bulletin 2007/36**

(73) Titulaires:
- **ECOLE POLYTECHNIQUE**
  **91128 Palaiseau cedex (FR)**
- **Centre National de la Recherche Scientifique**
  **75016 Paris (FR)**

(72) Inventeurs:
- **DE MARTINO, Antonello**
  **91300 MASSY (FR)**
- **DREVILLON, Bernard**
  **F-92140 Clamart (FR)**

(74) Mandataire: **Michelet, Alain et al**
**Cabinet Harlé et Phélip**
**7, rue de Madrid**
**75008 Paris (FR)**

(56) Documents cités:
**EP-A- 1 411 333       US-A- 5 956 145**
**US-B1- 6 804 003**

EP 1 828 712 B1

**Description**

L'invention concerne un procédé et dispositif de mesure par polarimétrie de circuits de microélectronique portant des motifs répétés régulièrement et formant les lignes d'un réseau.

Le développement de la fabrication des composants microélectroniques rend nécessaire des procédés et dispositifs de mesure et de contrôle de plus en plus performants.

En effet la diminution permanente de la dimension critique de ces circuits (CD : Critical Dimension) qui est actuellement de 100 nm environ implique l'adaptation correspondante des méthodes de mesure. Simultanément l'augmentation de la taille des galettes (wafer) et les coûts représentés par chacune d'elles impliquent le contrôle et la détection des défauts, dès que possible et, en fait, à chaque étape du processus de fabrication.

A cet effet, on utilise le fait que ces galettes portent des motifs qui sont répétés à l'identique. La répétition régulière d'un motif sur un support plan a pour effet la réalisation d'un objet se comportant, du point de vue de l'optique, comme un réseau. Les traits du réseau sont constitués par la répétition ordonnée du motif.

C'est ainsi que, jusqu'à présent les inventeurs de la présente demande ont utilisé, en laboratoire, l'ellipsométrie de Mueller dans différents domaines spectraux, pour la caractérisation des réseaux de diffraction.

Plus classiquement, l'ellipsométrie spectroscopique est utilisée dans l'industrie (souvent sous le nom de « scattéromètrie ») pour caractériser les circuits. Des mesures d'ellipsométrie spectroscopique sont alors réalisées à l'ordre zéro, c'est à dire que les faisceaux respectivement d'excitation et de mesure sont orientés, par rapport à l'objet mesuré, selon des angles liés par les lois de Descartes, le plan d'incidence étant perpendiculaire aux traits du réseau constitué par la répétition du motif.

Le but de la présente invention est d'améliorer ces méthodes de mesure existantes en augmentant leur précision et en augmentant le nombre et la nature des éléments des circuits caractérisés.

A cet effet, on peut augmenter le nombre de quantités mesurées par rapport à la technique « scattérométrique » standard. En premier lieu, on peut effectuer des mesures polarimétriques dans au moins deux plans d'incidence distincts, c'est-à-dire en faisant varier l'angle azimuthal. En deuxième lieu, ces mesures peuvent être plus complètes que les mesures ellipsométriques classiques. Ainsi, la détermination de toute la matrice de Mueller ou encore de ses valeurs propres fournissent respectivement seize ou quatre quantités au lieu des deux angles $\Psi$ et $\Delta$ (ou des quantités équivalentes) de l'ellipsométrie standard. Dans tous les cas, plus on acquiert de données, plus on peut, en principe, aboutir à une caractérisation précise et robuste de l'objet, mais au prix d'un temps de calcul qui peut devenir prohibitif. Il faut donc trouver un compromis entre le nombre de données mesurées et les possibilités de traitement.

L'invention propose donc un procédé et un dispositif de mesure qui tout en améliorant significativement les mesures antérieures est compatible avec les méthodes et moyens de traitement de données disponibles. Plus précisément, cette méthode et les appareils la mettant en oeuvre peuvent être pratiquement utilisés dans l'industrie. Les temps de traitement requis ne risquent pas de pénaliser la fabrication des circuits et sont compatibles avec les cadences de production.

La présente invention concerne donc un procédé de mesure par polarimétrie d'un objet plan portant des motifs répétés régulièrement et formant les lignes d'un réseau comprenant la production d'un faisceau incident d'excitation sur l'objet constituant un faisceau de mesure dont l'orientation par rapport à l'objet est représentée par un angle d'incidence $\theta$ et un angle azimuthal $\phi$.

Selon l'invention,

- on effectue une première mesure à l'ordre zéro, sous un angle d'incidence $\theta_1$ et pour un premier angle azimuthal $\phi_1$,
- on effectue au moins une deuxième mesure à l'ordre zéro, sous un angle d'incidence $\theta_2$ et pour un deuxième angle azimuthal $\phi_2$,
- la polarisation du faisceau incident est modulée et la polarisation du faisceau réfléchi est analysée pour chaque mesure de façon à obtenir des données polarimétriques expérimentales,
- on calcul des données polarimétriques théoriques pour un objet modèle de l'objet réel, l'objet modèle comportant des paramètres ajustables à l'aide d'un formalisme de l'électromagnétisme,
- on caractérise l'objet en faisant une comparaison itérative des mesures avec les données polarimétriques théoriques pour différentes valeurs des paramètres ajustables.

Dans différents mode de réalisation particuliers de l'invention présentant chacun leurs avantages spécifiques :

- les données polarimétriques théoriques et les mesures sont chacunes représentées par une matrice de Mueller complète,
- les données polarimétriques théoriques et les mesures sont obtenues à partir d'une combinaison linéaire des valeurs propres de la matrice de Mueller complète,
- les angles azimuthaux $\phi_1$ et $\phi_2$ sont compris entre 30° et 90°, avantageusement entre 30° et 60° par rapport à la direction de répétition des motifs,

- les mesures polarimétriques sont obtenues en fonction de la longueur d'onde de façon à obtenir des mesures spectroscopiques,
- la gamme spectrale de la longueur d'onde se situe dans le proche ultraviolet,
- la gamme spectrale de la longueur d'onde se situe dans le visible,
- la comparaison itérative est une méthode du type moindres carrés,
- le calcul des données polarimétriques théoriques utilise une méthode du type modèle de Weidner pour les réseaux à profil asymétrique.

L'invention concerne également un dispositif pour la mise en oeuvre du procédé de mesure par polarimétrie.

Selon un premier mode de réalisation de l'invention, le dispositif comporte deux polarimètres de Mueller comportant une source lumineuse, deux polarimètres comportant chacun un générateur d'état de polarisation (PSG), un analyseur d'état de polarisation (PSA) et un détecteur.

Selon l'invention, l'orientation azimuthale de l'un diffère de celle de l'autre et les points mesurés sur l'objet, par l'un et l'autre, sont superposés.

Selon un deuxième mode de réalisation de l'invention, le dispositif comporte une source lumineuse pour l'excitation d'un objet, un générateur d'état de polarisation (PSG), des moyens optiques aptes à diriger un flux lumineux d'excitation produit par la source vers l'objet, un analyseur d'état de polarisation (PSA), un détecteur apte à recevoir un flux lumineux de mesure produit par l'objet en réponse au flux d'excitation, des moyens optiques de mesure, collectant le flux lumineux de mesure produit par l'objet et le dirigeant vers le détecteur.

Selon l'invention, le deuxième dispositif comporte des moyens permettant au détecteur de produire des mesures distinctes fonction de l'angle azimuthal du flux lumineux d'excitation sur l'objet et de la polarisation du flux lumineux réfléchi.

Dans différents mode de réalisation particuliers de l'invention présentant chacun leurs avantages spécifiques :

- le dispositif comporte des moyens optiques tels que le faisceau lumineux d'excitation, au niveau de l'objet, présente une faible cohérence spatiale comprise entre 5 et 100 fois la limite de diffraction de la source,
- la source lumineuse est une source classique filtrée,
- la source lumineuse comprend un ou plusieurs lasers de longueurs d'onde différentes,
- le dispositif comporte une lame semi transparente permettant la séparation des flux lumineux respectivement d'excitation et de mesure,
- le dispositif comporte un objectif à grande ouverture numérique, ayant un plan de Fourier, apte à être traversé par le flux d'excitation et à le faire converger sur l'objet et également apte à collecter le flux de mesure produit par l'objet,
- les moyens optiques d'excitation comportent un masque, dans un plan optiquement conjugué du plan de Fourier de l'objectif, apte à produire des flux lumineux d'excitation incidents sur l'objet selon des angles azimuthaux différentiés,
- les moyens optiques de mesures comportent un masque, dans un plan optiquement conjugué du plan de Fourier de l'objectif, apte à collecter des flux lumineux de mesure émis par l'objet selon des angles azimuthaux différentiés,
- le détecteur est un détecteur multipoints, placé dans un plan optiquement conjugué du plan de Fourier de l'objectif et, apte à mesurer simultanément des flux lumineux de mesure émis par l'objet selon des angles azimuthaux différentiés,
- le PSG et le PSA comprennent des moyens pour moduler la polarisation du faisceau incident et des moyens pour analyser la polarisation du faisceau réfléchi, de façon à mesurer la totalité de la matrice de Mueller du réseau,
- le dispositif comporte des moyens pour effectuer des mesures polarimétriques en fonction de la longueur d'onde de façon à obtenir des mesures spectroscopiques,
- la gamme spectrale de la longueur d'onde se situe dans le proche ultraviolet,
- la gamme spectrale de la longueur d'onde se situe dans le visible.

Un mode de réalisation de l'invention sera décrit plus en détail en référence aux dessins annexés dans lesquels :

- la figure 1 est une représentation schématique d'un système de mesure polarimétrique, en faisant apparaître les principaux paramètres significatifs ;
- la figure 2 est une représentation schématique d'un dispositif de l'invention selon un premier mode de réalisation ;
- la figure 3 est une représentation schématique d'un dispositif de l'invention selon un second mode de réalisation ;
- les figures 4 et 5 représentent, vues en coupe, deux types de modèles géométriques, l'un figure 4 a des traits à flancs droits, l'autre figure 5 a des traits à flancs inclinés ;
- les figures 6 à 9 représentent les résultats comparatifs des mesures obtenues avec les modèles des figures 4 et 5 ;

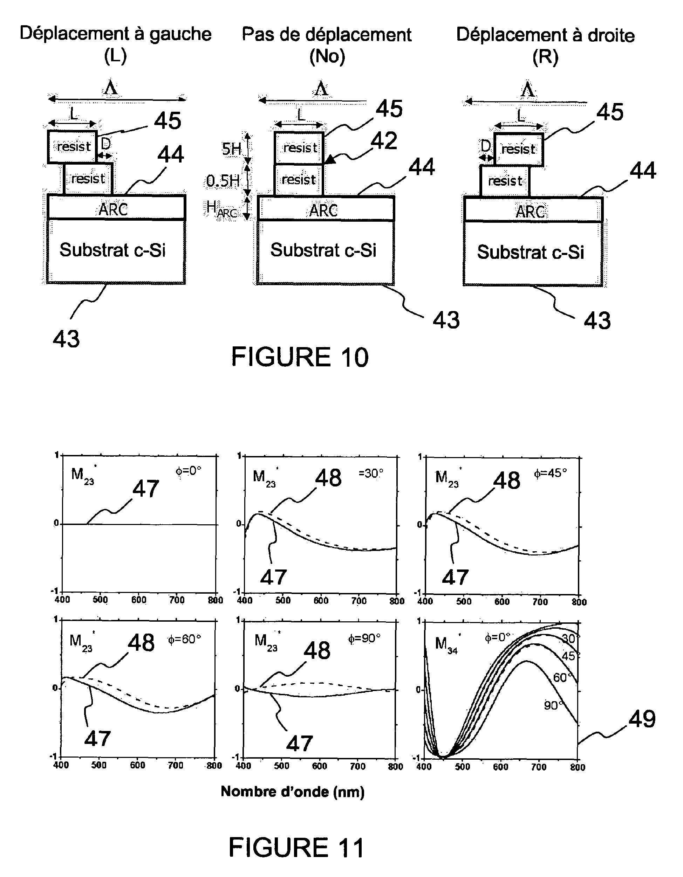

- la figure 10 représente les différents types de décalage (« overlay ») utiles à mesurer ;

- la figure 11 représente les résultats obtenus sur différents paramètres de la matrice de Mueller lors des mesures sur les objets de la figure 10 ;

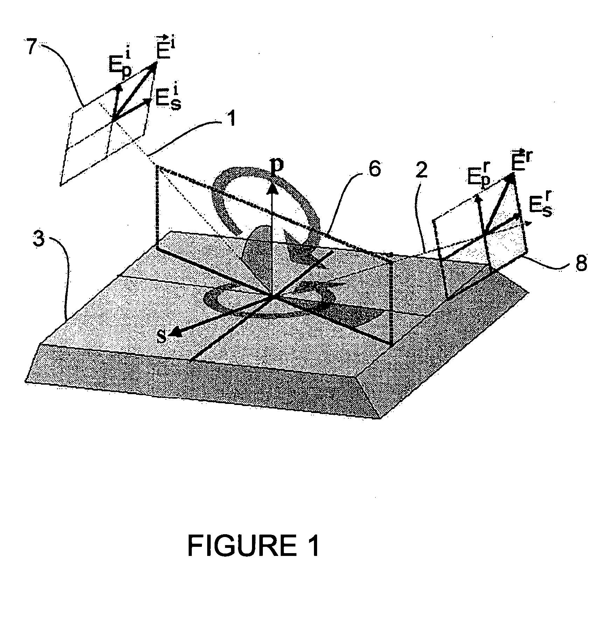

Sur la figure 1, un objet 3, plan, reçoit le faisceau d'excitation 1 et renvoie le faisceau de mesure 2. Ce faisceau d'excitation 1 est orienté par rapport à l'objet 3 sous un angle d'incidence $\theta$. Le plan d'incidence 6 est orienté sous l'angle azimuthal $\phi$. On s'intéresse ici à l'ordre zéro, c'est-à-dire que, comme indiqué plus haut, les faisceaux respectivement d'excitation 1 et de mesure 2 sont orientés, par rapport à l'objet 3 mesuré, selon des angles liés par les lois de Descartes. Les paramètres de polarisation des faisceaux d'incidence 1 et de mesure 2 sont respectivement représentés sur les repères 7 et 8. Les vecteurs polarisation, respectivement E' et E' incident et réfléchi, sont décomposés sur des axes orthogonaux en $E^i_p$ $E^i_s$ et $E^r_p$ $E^r_s$.

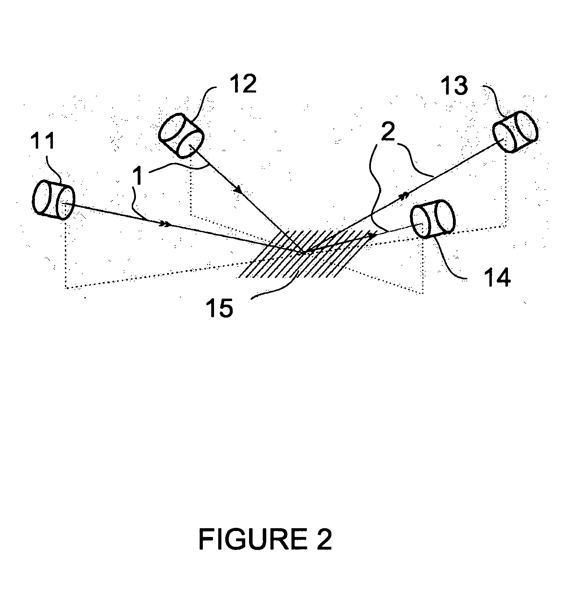

La figure 2 schématise un premier mode de réalisation de l'invention. L'objet 15 porte des motifs qui sont schématisés par la direction de leur répétition. Deux polarimètres de Mueller sont schématisés par leurs générateurs d'états de polarisation (Polarization State Generator - PSG) respectifs 11 et 12 et par leurs analyseurs d'état de Polarisation (Polarization State Analysers - PSA) respectifs 13 et 14. Par simplification, les sources lumineuses et les détecteurs ne sont pas représentés. Un faisceau incident d'excitation 1 est produit sur l'objet constituant un faisceau de mesure dont l'orientation par rapport à l'objet est représentée par un angle d'incidence $\theta$ et un angle azimuthal $\phi$.

Selon l'invention, lors de la mesure, on effectue, avec l'un des polarimètres, une première mesure à l'ordre zéro, sous un angle d'incidence $\theta_1$ et sous un premier angle azimuthal $\phi_1$ de façon à obtenir les données polarimétriques correspondantes.

On effectue simultanément, avec l'autre des polarimètres, au moins une deuxième mesure à l'ordre zéro, sous un angle d'incidence $\theta_2$ et sous un deuxième angle azimuthal $\phi_2$ de façon à obtenir les données polarimétriques correspondantes.

Les PSG 11, 12 et les PSA 13, 14 comprennent des moyens pour moduler la polarisation du faisceau incident 1 et des moyens pour analyser la polarisation du faisceau réfléchi 2, de façon à mesurer simultanément la totalité des deux matrices de Mueller soit 16 données polarimétriques par matrice, à des angles azimuthaux $\phi_1$ et $\phi_2$ différents.

Les polarimètres sont réglés de telle sorte que les points mesurés sur l'objet 15, par l'un et l'autre, sont précisément superposés.

Ces mesures pourront être réalisées à différentes longueurs d'onde, dans un domaine qui s'étendra typiquement sur le visible et/ou l'ultraviolet jusqu'à environ 200 nm.

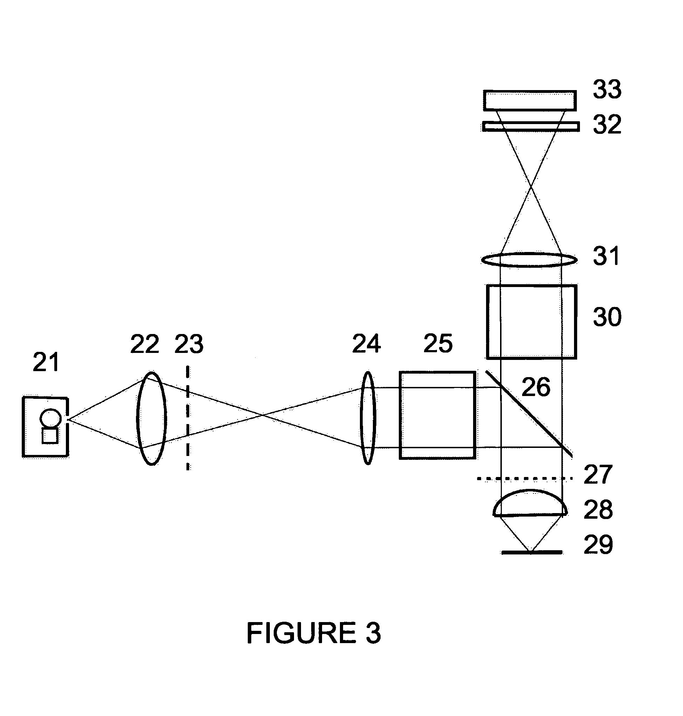

La figure 3 représente un autre mode de réalisation de l'invention fonctionnant dans le visible mettant en oeuvre un polarimètre de Mueller à résolution angulaire. Il comporte un générateur d'état de polarisation (PSG) 25 agissant sur le flux lumineux parallèle produit par la source 21, la lentille 22, le masque 23 et la lentille 24 et un analyseur d'état de polarisation (PSA) 30 agissant sur le flux lumineux parallèle par un objectif à grande ouverture numérique, avantageusement supérieure à 0,95, du type objectif de microscope 28 reçu de l'objet 29. La grande ouverture numérique permet d'obtenir un grand balayage d'angle au niveau du détecteur.

Le dispositif selon ce deuxième mode de réalisation comporte des moyens optiques de sorte que le faisceau lumineux d'excitation, au niveau de l'objet, présente une faible cohérence spatiale comprise entre 5 et 100 fois la limite de diffraction de la source 21. La source 21 peut être constituée d'une source blanche classique filtrée ou bien d'un ou plusieurs lasers de longueurs d'onde différentes à faible cohérence, le but étant d'éclairer le plus grand nombre de traits.

Une lame semi transparente 26 permet la séparation des faisceaux d'excitation et de mesure. La lentille 31, dirige le flux lumineux sortant du PSA vers le récepteur multipoint 33 au travers du filtre 32.

Le PSG 25 est constitué d'un polariseur linéaire et de deux cristaux liquides (LC), ferroélectriques ou nématiques. Une lame quart d'onde peut être insérée entre les deux LC afin d'améliorer les performances de l'appareil. Le PSA 30 est constitué, de manière symétrique, de deux LC et d'un polariseur linéaire (ou analyseur). L'orientation et les déphasages de chacun des LC (identiques pour le PSG et le PSA) correspondent à des valeurs optimisées. Le récepteur multipoint 33 est une caméra CCD, couplée à un monochromateur. La mesure complète de la matrice de Mueller (seize coefficients au lieu de deux en ellipsométrie classique) est obtenue à partir de seize mesures, en appliquant consécutivement deux valeurs de déphasage aux cristaux liquides, dont l'orientation est fixe. Compte tenu des temps de commutation des CL, cette mesure spectroscopique, dans le domaine du visible, est effectuée en une seconde environ.

Pour un fonctionnement dans l'ultraviolet, domaine spectral où les cristaux liquides sont opaques, on pourra utiliser un PSG composé d'un polariseur et d'une lame retard adaptée à la longueur d'onde de fonctionnement de l'objectif, et qui pourra être placée à au moins quatre orientations différentes par rotation dans son plan. Le PSA est composé des mêmes éléments, traversés en sens inverse. L'objectif pourra être soit un objectif miroir, dont l'avantage est l'achromaticité, soit un objectif utilisé pour la lithographie UV, prévu pour une longueur d'onde donnée (typiquement 248 nm), l'avantage étant alors une meilleure transmission et une plus grande ouverture numérique par rapport aux valeurs typiques des objectifs à miroir.

La diffraction conique consiste à effectuer des mesures avec des angles azimuthaux différents. Utilisée conjointement, la polarimétrie de Mueller présente de nombreux avantages par rapport à la scatterométrie conventionnelle.

En effet la polarimètrie de Mueller apporte une meilleure précision sur la détermination de certains paramètres des réseaux (par exemple dans le cas de traits trapézoïdaux). En outre, elle permet de résoudre certaines ambiguïtés inhérentes à la scattérométrie conventionnelle, par exemple dans le cas de structures superposées (dites « overlay » en microélectronique).

Quelque soit le mode de réalisation, on calcule parallèlement les données polarimétriques théoriques pour un objet modèle de l'objet réel. L'objet modèle comporte des paramètres ajustables à l'aide d'un formalisme de l'électromagnétisme.

Les données polarimétriques théoriques et les mesures sont chacunes soit représentées par une matrice de Mueller complète, soit une combinaison linéaire de ses valeurs propres.

Le mode opératoire, simplifié, pour obtenir les valeurs propres de la matrice de Mueller est décrit ci-dessous. Ce mode opératoire fournit les 4 valeurs propres de la matrice $\mathbf{M}\,\mathbf{M}_0^{-1}$, où $\mathbf{M}$ est la matrice de Mueller de l'objet à caractériser et $\mathbf{M}_0$ la matrice de Mueller supposée bien connue et non singulière, d'un objet de référence. Ce mode opératoire constitue donc un intermédiaire entre l'ellipsométrie classique, qui en fournit que deux grandeurs, et la polarimétrie de Mueller complète, qui donne les 16 éléments de la matrice.

Le principal intérêt de ce mode opératoire est sa facilité de mise en oeuvre, puisqu'il ne nécessite pas de calibration complète du (ou des) polarimètre(s). On procède comme suit :

- dans un premier temps, on mesure la matrice de référence $\mathbf{B}_0 = \mathbf{A}\,\mathbf{M}_0\,\mathbf{W}$ de l'objet de référence de matrice de Mueller $\mathbf{M}_0$, (cet objet pourra être par exemple du silicium, éventuellement avec une couche d'oxyde d'épaisseur connue, ou du verre),
- pour l'objet à caractériser, on mesure la matrice $\mathbf{B = AMW}$, et on forme les produits

$$\mathbf{B}_0^{-1}\,\mathbf{B} = \mathbf{W}^{-1}\,\mathbf{M}_0^{-1}\,\mathbf{M}\,\mathbf{W} \quad \text{et} \quad \mathbf{B}\,\mathbf{B}_0^{-1} = \mathbf{A}\,\mathbf{M}\,\mathbf{M}_0^{-1}\,\mathbf{A}^{-1}$$

Ces matrices produits ont les mêmes valeurs propres que $\mathbf{M}_0^{-1}\,\mathbf{M}$ et $\mathbf{M}\,\mathbf{M}_0^{-1}$, qu'on peut donc déterminer sans connaître ni $\mathbf{A}$, ni $\mathbf{W}$. Ces valeurs propres étant en principe les mêmes pour les deux produits, on dispose d'un test simple de la précision des mesures. Par ailleurs, $\mathbf{M}_0$ étant supposée connue, tout modèle théorique utilisé pour reconstruire la forme des traits du réseau à partir de la matrice $\mathbf{M}$ peut être utilisé tout aussi bien, avec un temps de calcul à peine plus long, avec les valeurs propres de $\mathbf{M}\,\mathbf{M}_0^{-1}$.

On caractérise ensuite l'objet en faisant une comparaison itérative des mesures avec les données polarimétriques théoriques pour différentes valeurs des paramètres ajustables.

On détermine les valeurs optimales des paramètres de l'objet modèle par une méthode itérative du type des moindres carrés, comme par exemple la méthode du $\chi^2$.

Le calcul peut utiliser également une méthode du type modèle de Weidner pour les réseaux à profil asymétrique.

Les avantages selon l'invention sont illustrés ci-après par deux exemples.

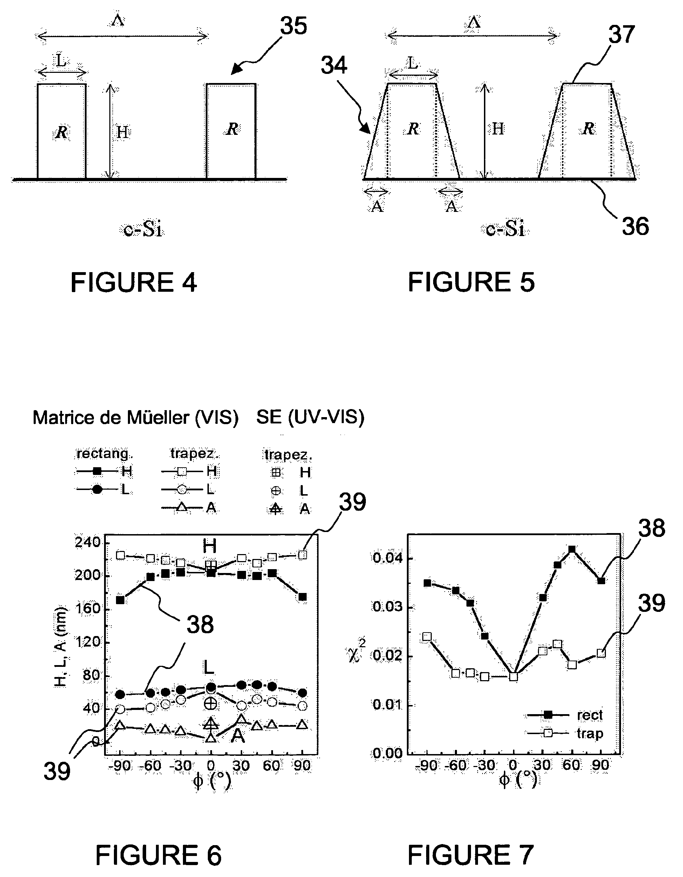

Le premier de ces exemples, représenté sur les figures 4 à 7, montre la possibilité de mesurer précisément la forme de la section des traits et tout particulièrement de distinguer le modèle le mieux adapté entre le modèle 34 avec des traits ayant des flancs inclinés et le modèle 35 avec des traits ayant des flancs droits pour un même objet.

On a comparé les résultats obtenus avec un polarimètre spectroscopique de Mueller travaillant dans le visible (450-750 nm) sous plusieurs angles azimuthaux avec les résultats obtenus par ellipsométrie conventionnelle sous un seul angle ($\phi$=0°) dans un domaine spectral plus étendu (250-800 nm).

L est la largeur du trait, H sa hauteur et, dans le cas des objets 34 à flancs inclinés, A est la demi-différence entre la largeur du trait à sa base 36 et à son sommet 37. La période du réseau est ^.

Les valeurs nominales de ces paramètres sont :

^ = 240 nm,
H = 230 nm,
L = 70 nm,
A = 0 nm.

Ces valeurs sont prises comme point de départ pour le calcul par la méthode des moindres carrés ($\chi^2$) qui se calcule en effectuant une série de mesures :

- portant sur $N$ grandeurs ellipsométriques $Y_i$, où l'indice varie de 1 à $N$ (par exemple, dans le cas de l'ellipsométrie classique $Y_1 = \psi$, $Y_2 = \Delta$ et donc $N = 2$ ; alors qu'en polarimétrie de Mueller $N=16$ puisque les $Y_i$ sont les 16 éléments de la matrice complète),

- sur un ensemble de *M* longueurs d'onde λ$_j$, (1≤*j*≤*M*),
- sur un ensemble de *P* valeurs des angles polaire θ$_k$ et azimuthal φ$_k$ (1≤*k*≤*P*)

et on ajuste les valeurs expérimentales de *Y*$_i$, soit $Y_i^{\exp}\left(\lambda_j,\theta_k,\phi_k\right)$ par un modèle qui donne des valeurs théoriques $Y_i^{th}$ de ces mêmes grandeurs *Y*$_i$.

Le χ$^2$ correspondant à cet ensemble de mesures et de simulations s'écrit :

$$\chi^2 = \frac{1}{NMP}\sum_{i,j,k}\left(Y_i^{\exp}(\lambda_j,\theta_k,\phi_k) - Y_i^{th}(\lambda_j,\theta_k,\phi_k)\right)^2$$

La figure 6 représente les valeurs de paramètres obtenues pour l'un et l'autre des modèles, à traits droits 35 et à traits inclinés 34, par une mesure classique d'ellipsométrie et par polarimétrie de Mueller pour différents angles azimuthaux φ. Les paramètres en nm sont représentés en fonction de l'angle azimuthal φ. La polarimétrie de Mueller permet de distinguer le modèle le mieux adapté. Les courbes 38 et 39 des deux modèles sont bien distinctes. Idéalement, les courbes devraient être indépendantes de φ. C'est la courbe 39 correspondant au modèle à traits inclinés 34 qui présente le moins de dépendance.

La figure 7 représente les valeurs du χ$^2$ obtenues par polarimétrie de Mueller pour les deux modèles. Les variations du χ$^2$ en fonction de l'angle azimuthal φ permettent de distinguer le modèle le mieux adapté. Le χ$^2$ c'est à dire la différence entre les valeurs mesurées et simulées est la plus faible pour le modèle à traits inclinés 34, représenté par la courbe 39, qui est par conséquent le modèle le mieux adapté.

On vérifie ainsi que la méthode selon l'invention permet une détermination nette du modèle le mieux adapté, ce qui n'est pas accessible par la mesure classique.

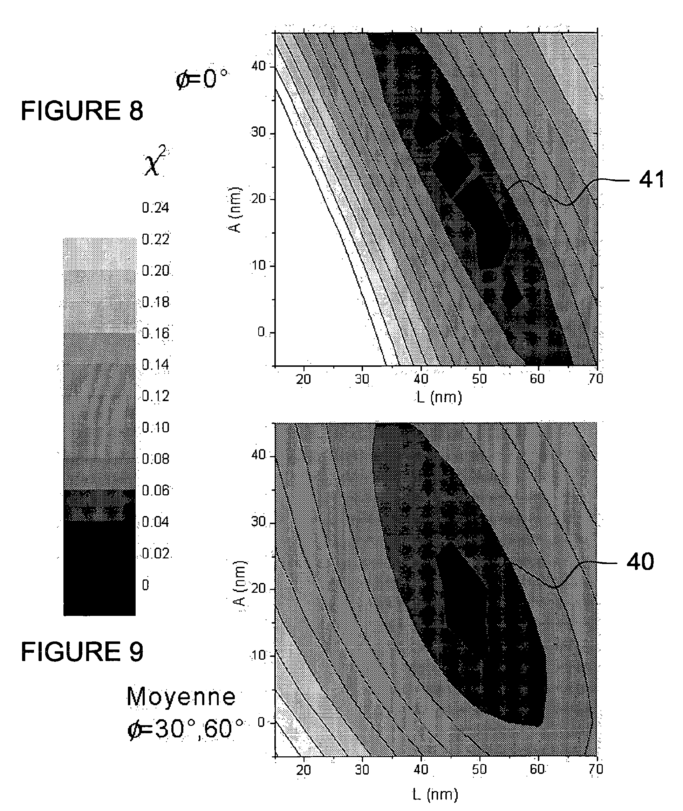

Les figures 8 et 9 sont des représentations du paramètre χ$^2$ en fonction des paramètres A et L comparées aux mesures prises à un angle azimuthal φ = 0° (figure 8) et à la moyenne des mesures prises à φ = 30° et φ = 60° en polarimétrie de Mueller (figure 9). Il ressort ainsi, comme attendu qu'avec deux mesures sous les angles de 30° et 60° la convergence 40 est obtenue sans ambiguïté possible alors, qu'avec la seule mesure à 0°, le point de convergence 41 est incertain et ne permet donc pas une mesure précise.

Il est ainsi confirmé que les mesures sous les angles de 30° et 60° permettent de lever l'indétermination.

Les mesures doivent donc être effectuées sous des angles compris entre 30° et 60°, sans exclure une mesure jusqu'à un angle de 90°.

Le deuxième exemple consiste en la mesure d'un décalage («overlay») des couches entre elles, dans un empilement. Un tel décalage, dans un sens ou l'autre est schématisé sur la figure 12 par rapport à un empilement parfait 42, sans décalage représenté au centre.

Les paramètres définissant cet empilement sont la largeur du trait L, la hauteur totale de l'empilement H et le décalage D. La période du réseau est ^.

On utilise le modèle proposé par Weidner et al (Proc SPIE, 5375 (2004)). Un substrat 43 de silicium Si est recouvert d'une couche anti-réflexion 44 (ARC) d'épaisseur 90 nm. Sur cette couche, une couche de résine 45 est déposée qui forme un réseau de pas ^ = 145 nm. Le réseau obtenu est plus précisément formé de deux réseaux de même dimension L = 58 nm (i.e. ^/4), de même hauteur 0,5 H = 50 nm, et présentant un décalage D = 14,5 nm (i.e. U4).

Les simulations d'après le modèle de Weidner et al sur la figure 13 font apparaître des résultats pour des déplacements à droite (R) et à gauche (L) pour deux éléments normalisés de la matrice : M$_{23}^*$ = M$_2$/M$_{11}$ et M$_{34}^*$ = M$_{34}$/M$_{11}$. L'élément M$_{23}^*$ est obtenu seulement à partir des mesures par polarimétrie de Mueller alors que l'élément M$_{34}^*$ est donné par la polarimétrie de Mueller et l'ellipsométrie standard. La courbe en trait plein 47 et la courbe en trait interrompu 48 correspondent respectivement aux déplacements à droite (R) et à gauche (L). Ces courbes sont représentées en fonction du nombre d'onde (nm) et pour différents angles azimuthaux.

La représentation 49 de l'élément M$_{34}^*$ en fonction du nombre d'onde pour des angles azimuthaux φ variant de 0° à 90° montre que le modèle de Weidner et al ne produit aucune différence significative du sens du décalage quelque soit l'angle φ. Les courbes obtenues pour des déplacements à droite 47 et à gauche 48 sont quasiment superposées. Au contraire, le paramètre M$_{23}^*$, qui n'est valable qu'en polarisation de Mueller, permet une distinction significative entre les déplacements à droite ou à gauche sauf pour φ=0°, mais avec la plus grande sensibilité pour φ=90°.

Quelque soit la méthode de calcul utilisée, la polarimétrie de Mueller selon l'invention, comprenant des mesures sous plusieurs angles azimuthaux permet l'obtention d'un plus grand nombre de paramètres, ce qui entraîne une caractérisation plus précise et plus complète d'un objet.

**Revendications**

1. Procédé de mesure par polarimétrie d'un objet plan portant des motifs répétés régulièrement et formant les lignes d'un réseau comprenant la production d'un faisceau incident d'excitation sur ledit objet constituant un faisceau de mesure dont l'orientation par rapport à l'objet est représentée par un angle d'incidence $\theta$ et un angle azimuthal $\phi$, comportant les étapes suivantes

   - on effectue une première mesure à l'ordre zéro, sous un angle d'incidence $\theta_1$ et pour un premier angle azimuthal $\phi_1$,
   - on effectue au moins une deuxième mesure à l'ordre zéro, sous un angle d'incidence $\theta_2$ et pour un deuxième angle azimuthal $\phi_2$,
   - la polarisation du faisceau incident est modulée et la polarisation du faisceau réfléchi est analysée pour chaque mesure de façon à obtenir des données polarimétriques expérimentales,
   - on calcul des données polarimétriques théoriques pour un objet modèle de l'objet réel, ledit objet modèle comportant des paramètres ajustables à l'aide d'un formalisme de l'électromagnétisme,
   - on caractérise l'objet en faisant une comparaison itérative des mesures avec les données polarimétriques théoriques pour différentes valeurs des paramètres ajustables.

2. Procédé de mesure par polarimétrie selon la revendication 1, **caractérisé en ce que** les données polarimétriques théoriques et les mesures sont chacunes représentées par une matrice de Mueller complète.

3. Procédé de mesure par polarimétrie selon la revendication 2, **caractérisé en ce que** les données polarimétriques théoriques et les mesures sont obtenues à partir d'une combinaison linéaire des valeurs propres de la matrice de Mueller complète.

4. Procédé de mesure par polarimétrie selon l'une quelconque des revendications 1 à 3, **caractérisé en ce que** les angles azimuthaux $\phi_1$ et $\phi_2$ sont compris entre 30° et 90°, avantageusement entre 30° et 60° par rapport à la direction de répétition des motifs.

5. Procédé de mesure par polarimétrie selon l'une quelconque des revendications 1 à 4, **caractérisé en ce que** les mesures polarimétriques sont obtenues en fonction de la longueur d'onde de façon à obtenir des mesures spectroscopiques.

6. Procédé de mesure par polarimétrie selon la revendication 5, **caractérisé en ce que** la gamme spectrale de la longueur d'onde se situe dans le proche ultraviolet.

7. Procédé de mesure par polarimétrie selon la revendication 5, **caractérisé en ce que** la gamme spectrale de la longueur d'onde se situe dans le visible.

8. Procédé de mesure par polarimétrie selon l'une quelconque des revendications 1 à 7, **caractérisé en ce que** la comparaison itérative est une méthode du type moindres carrés.

9. Procédé de mesure par polarimétrie selon l'une quelconque des revendications 1 à 8, **caractérisé en ce que** le calcul des données polarimétriques théoriques utilise une méthode du type modèle de Weidner pour les réseaux à profil asymétrique.

10. Dispositif comportant des moyens de mise en oeuvre du procédé de mesure par polarimétrie selon l'une quelconque des revendications 1 à 9, comportant en outre une source lumineuse, deux polarimètres comportant chacun un générateur d'état de polarisation (PSG) (11, 12), un analyseur d'état de polarisation (PSA) (13, 14) et un détecteur, tel que

    - l'orientation azimuthale de l'un $\phi_1$ diffère de celle de l'autre $\phi_2$,
    - les points mesurés sur l'objet, par l'un et l'autre, sont superposés.

11. Dispositif comportant des moyens de mise en oeuvre du procédé de mesure par polarimétrie selon l'une quelconque des revendications 1 à 9, comportant en outre une source lumineuse (21) pour l'excitation d'un objet (29), un générateur d'état de polarisation (PSG) (25), des moyens optiques aptes à diriger un flux lumineux d'excitation produit par la source (21) vers l'objet (29), un analyseur d'état de polarisation (PSA) (30), un détecteur (33) apte à recevoir un flux lumineux de mesure produit par l'objet (29) en réponse au flux d'excitation, des moyens optiques de mesure, collectant le flux lumineux de mesure produit par l'objet (29) et le dirigeant vers le détecteur (33), comportant en outre des moyens permettant au détecteur de produire des mesures distinctes fonction de l'angle azimuthal du flux lumineux d'excitation sur l'objet (29) et de la polarisation du flux lumineux réfléchi.

12. Dispositif pour la mise en oeuvre du procédé de mesure par polarimétrie selon la revendication 11, **caractérisé en ce qu'**il comporte des moyens optiques tels que le faisceau lumineux d'excitation, au niveau de l'objet, présente une faible cohérence spatiale comprise entre 5 et 100 fois la limite de diffraction de la source (21).

13. Dispositif pour la mise en oeuvre du procédé de mesure par polarimétrie selon la revendication 12, **caractérisé en ce que** la source lumineuse (21) est une source classique filtrée.

14. Dispositif pour la mise en oeuvre du procédé de mesure par polarimétrie selon la revendication 12, **caractérisé en ce que** la source lumineuse (21) comprend un ou plusieurs lasers de longueurs d'onde différentes.

15. Dispositif pour la mise en oeuvre du procédé de mesure par polarimétrie selon l'une quelconque des revendications 11 à 14, **caractérisé en ce qu'**il comporte une lame semi transparente (26) permettant la séparation des flux lumineux respectivement d'excitation et de mesure.

16. Dispositif pour la mise en oeuvre du procédé de mesure par polarimétrie selon l'une quelconque des revendications 11 à 15, **caractérisé en ce qu'**il comporte un objectif à grande ouverture numérique, ayant un plan de Fourier, apte à être traversé par le flux d'excitation et à le faire converger sur l'objet (29) et également apte à collecter le flux de mesure produit par l'objet (29).

17. Dispositif pour la mise en oeuvre du procédé de mesure par polarimétrie selon l'une quelconque des revendications 11 à 16, **caractérisé en ce que** les moyens optiques d'excitation comportent un masque, dans un plan optiquement conjugué du plan de Fourier de l'objectif, apte à produire des flux lumineux d'excitation incidents sur l'objet (29) selon des angles azimuthaux différentiés.

18. Dispositif pour la mise en oeuvre du procédé de mesure par polarimétrie selon l'une quelconque des revendications 11 à 17, **caractérisé en ce que** les moyens optiques de mesures comportent un masque, dans un plan optiquement conjugué du plan de Fourier de l'objectif, apte à collecter des flux lumineux de mesure émis par l'objet (29) selon des angles azimuthaux différentiés.

19. Dispositif pour la mise en oeuvre du procédé de mesure par polarimétrie selon l'une quelconque des revendications 11 à 18, **caractérisé en ce que** le détecteur est un détecteur multipoints, placé dans un plan optiquement conjugué du plan de Fourier de l'objectif et, apte à mesurer simultanément des flux lumineux de mesure émis par l'objet (29) selon des angles azimuthaux différentiés.

20. Dispositif pour la mise en oeuvre du procédé de mesure par polarimétrie selon l'une quelconque des revendications 10 à 19, **caractérisé en ce que** le PSG (25) et le PSA (30) comprennent des moyens pour moduler la polarisation du faisceau incident et des moyens pour analyser la polarisation du faisceau réfléchi, de façon à mesurer la totalité de la matrice de Mueller du réseau.

21. Dispositif pour la mise en oeuvre du procédé de mesure par polarimétrie selon l'une quelconque des revendications 10 à 20, **caractérisé en ce qu'**il comporte des moyens pour effectuer des mesures polarimétriques en fonction de la longueur d'onde de façon à obtenir des mesures spectroscopiques.

22. Dispositif pour la mise en oeuvre du procédé de mesure par polarimétrie selon la revendication 21, **caractérisé en ce que** la gamme spectrale de la longueur d'onde se situe dans le proche ultraviolet.

23. Dispositif pour la mise en oeuvre du procédé de mesure par polarimétrie selon la revendication 21, **caractérisé en ce que** la gamme spectrale de la longueur d'onde se situe dans le visible.

**Claims**

1. A polarimetric measurement method of a planar object carrying patterns repeated regularly and forming the lines of a grid including the generation of an excitation incident beam on said object forming a measuring beam whereof the orientation relative to the object is represented by an angle of incidence $\theta$ and an azimuthal angle $\phi$, including the following steps:

- a first measuring is carried out at zero order, under an angle of incidence $\theta_1$ and for a first azimuthal angle $\phi_1$,
- a second measurement at least is carried out at zero order, under an angle of incidence $\theta_2$ and for a second azimuthal angle $\phi_2$,
- the polarisation of the incident beam is modulated and the polarisation of the reflected beam is analysed for each measurement so as to obtain experimental polarimetric data,
- theoretical polarimetric data is calculated for a model object of the real object, said model object including parameters adjustable using a formalism of electromagnetism,
- the object is **characterised by** conducting an iterative comparison of the measurements with the theoretical polarimetric data for different values of the adjustable parameters.

2. A polarimetric measurement method according to claim 1, **characterised in that** the theoretical polarimetric data and the measurements are each represented by a complete Mueller matrix.

3. A polarimetric measurement method according to claim 2, **characterised in that** the theoretical polarimetric data and the measurements are obtained from a linear combination of the eigenvalues of the complete Mueller matrix.

4. A polarimetric measurement method according to any of the claims 1 to 3, **characterised in that** the azimuthal angles $\phi_1$ and $\phi_2$ are comprised between 30° and 90°, advantageously between 30° and 60° relative to the repeat direction of the patterns.

5. A polarimetric measurement method according to any of the claims 1 to 4, **characterised in that** the polarimetric measurements are obtained in relation to the wavelength so as to obtain spectroscopic measurements.

6. A polarimetric measurement method according to claim 5, **characterised in that** the spectral range of the wavelength is situated in the near ultraviolet.

7. A polarimetric measurement method according to claim 5, **characterised in that** the spectral range of the wavelength is situated in the visible.

8. A polarimetric measurement method according to any of the claims 1 to 7, **characterised in that** the iterative comparison is a method of the least square type.

9. A polarimetric measurement method according to any of the claims 1 to 8, **characterised in that** the calculation of the theoretical polarimetric data uses a method of the Weidner model type for the grids with asymmetrical profile.

10. A device for the implementation of the polarimetric measurement method according to any of the claims 1 to 9, including a light source, two polarimeters each including a polarisation state generator (PSG) (11, 12), a polarisation state analyser (PSA) (13, 14) and a detector, **characterised in that**:

- the azimuthal orientation of one $\phi_1$ differs from that of the other $\phi_2$,
- the points measured on the object, by one and the other, are superimposed.

11. A device for the implementation of the polarimetric measurement method according to any of the claims 1 to 9, including a light source (21) for the excitation of an object (29), a polarisation state generator (PSG) (25), optical means capable of directing an excitation luminous flux generated by the source (21) towards the object (29), a polarisation state analyser ( PSA) (30), a detector (33) capable of receiving a measurement luminous flux generated by the object (29) in response to the excitation flux, measuring optical means, collecting the measurement luminous flux generated by the object (29) and directing it towards the detector (33), **characterised in that** it includes means enabling the detector to generate distinct measurements according to the azimuthal angle of the excitation luminous flux on the object (29) and the polarisation of the reflected luminous flux.

12. A device for the implementation of the polarimetric measurement method according to claim 11, **characterised in that** it includes optical means such as the excitation light beam, at the object, exhibits a weak spatial coherence ranging between 5 and 100 times the diffraction limit of the source (21).

**13.** A device for the implementation of the polarimetric measurement method according to claim 12, **characterised in that** the light source (21) is a filtered conventional source.

**14.** A device for the implementation of the polarimetric measurement method according to claim 12, **characterised in that** the light source (21) includes one or several lasers of different wavelengths.

**15.** A device for the implementation of the polarimetric measurement method according to any of the claims 11 to 14, **characterised in that** it, includes a semi-transparent blade (26) enabling to separate the luminous fluxes, respectively excitation and measurement fluxes.

**16.** A device for the implementation of the polarimetric measurement method according to any of the claims 11 to 15, **characterised in that** it includes a wide digital aperture objective, having a Fourier plane, capable of being travelled by the excitation flux and of making it converge on the object (29) and also capable of collecting the measurement flux generated by the object (29).

**17.** A device for the implementation of the polarimetric measurement method according to any of the claims 11 to 16, **characterised in that** the optical excitation means include a mask, in an optically conjugated plane of the Fourier plane of the objective, capable of generating excitation luminous fluxes incident on the object (29) according to differentiated azimuthal angles.

**18.** A device for the implementation of the polarimetric measurement method according to any of the claims 11 to 17, **characterised in that** the optical measuring means include a mask, in an optically conjugated plane of the Fourier plane of the objective, capable of collecting the measurement luminous fluxes emitted by the object (29) according to differentiated azimuthal angles.

**19.** A device for the implementation of the polarimetric measurement method according to any of the claims 11 to 18, **characterised in that** the detector is a multipoint detector, placed in an optically conjugated plane of the Fourier plane of the objective and, capable of measuring simultaneously measurement luminous fluxes emitted by the object (29) according to differentiated azimuthal angles.

**20.** A device for the implementation of the polarimetric measurement method according to any of the claims 10 to 19, **characterised in that** the PSG (25) and the PSA (30) include means for modulating the polarisation of the incident beam and means for analysing the polarisation of the reflected beam, so as to measure the whole Mueller matrix of the grid.

**21.** A device for the implementation of the polarimetric measurement method according to any of the claims 10 to 20, **characterised in that** it includes means for conducting polarimetric measurements in relation to the wavelength so as to obtain spectroscopic measurements.

**22.** A device for the implementation of the polarimetric measurement method according to claim 21, **characterised in that** the spectral range of the wavelength is situated in the near ultraviolet.

**23.** A device for the implementation of the polarimetric measurement method according to claim 21, **characterised in that** the spectral range of the wavelength is situated in the visible.

**Patentansprüche**

**1.** Verfahren zum Messen eines ebenen Objekts, welches Motive aufweist, welche regelmäßig wiederholt sind und Linien eines Netzes bilden, durch Polarimetrie, umfassend die Erzeugung eines einfallenden Strahlenbündels zur Anregung auf dem Objekt, welches ein Strahlenbündel zur Messung bildet, deren Orientierung bezüglich des Objekts durch einen Einfallswinkel $\theta$ und einen Azimutwinkel $\Phi$ dargestellt ist, wobei das Verfahren die folgenden Schritte umfasst:

- eine erste Messung wird bei der nullten Ordnung unter einem Einfallswinkel $\theta_1$ und für einen ersten Azimutwinkel $\Phi_1$ durchgeführt,
- es wird zumindest eine zweite Messung bei der nullten Ordnung unter einem Einfallswinkel $\theta_2$ und für einen zweiten Azimutwinkel $\Phi_2$ durchgeführt,

- die Polarisation des einfallenden Strahlenbündels wird moduliert und die Polarisation des reflektierten Bündels wird für jede Messung in einer Weise analysiert, experimentelle polarimetrische Daten zu erhalten,

- theoretische polarimetrische Daten werden für ein nach dem realen Objekt modelliertes Objekt berechnet, wobei das modellierte Objekt mit Hilfe eines Formalismus des Elektromagnetismus einstellbare Parameter umfasst,

- das Objekt wird charakterisiert, indem ein iterativer Vergleich der Messungen mit dem theoretischen polarimetrischen Daten für verschiedene Werte der einstellbaren Parameter durchgeführt wird.

2. Verfahren zum Messen durch Polarimetrie gemäß Anspruch 1, **dadurch gekennzeichnet, dass** die theoretischen polarimetrischen Daten und die Messungen jeweils durch eine vollständige Mueller-Matrix dargestellt sind.

3. Verfahren zum Messen durch Polarimetrie gemäß Anspruch 2, **dadurch gekennzeichnet, dass** die theoretischen polarimetrischen Daten und die Messungen ausgehend von einer Linearkombination von Eigenwerten der vollständigen Mueller-Matrix erhalten werden.

4. Verfahren zum Messen durch Polarimetrie gemäß einem der Ansprüche 1-3, **dadurch gekennzeichnet, dass** die Azimutwinkel $\Phi_1$ und $\Phi_2$ zwischen 30° und 90°, vorteilhafterweise zwischen 30° und 60°, bezüglich der Richtung der Wiederholung der Motive enthalten sind.

5. Verfahren zum Messen durch Polarimetrie gemäß einem der Ansprüche 1-4, **dadurch gekennzeichnet, dass** die polarimetrischen Messungen in Abhängigkeit von der Wellenlänge in einer Weise erhalten werden, spektroskopische Messungen zu erhalten.

6. Verfahren zum Messen durch Polarimetrie gemäß Anspruch 5, **dadurch gekennzeichnet, dass** der Spektralbereich der Wellenlänge im nahen Ultraviolett liegt.

7. Verfahren zum Messen durch Polarimetrie gemäß Anspruch 5, **dadurch gekennzeichnet, dass** der Spektralbereich der Wellenlänge im Sichtbaren liegt.

8. Verfahren zum Messen durch Polarimetrie gemäß einem der Ansprüche 1-7, **dadurch gekennzeichnet, dass** der iterative Vergleich ein Verfahren von der Art der kleinsten Quadrate ist.

9. Verfahren zum Messen durch Polarimetrie gemäß einem der Ansprüche 1-8, **dadurch gekennzeichnet, dass** die Berechnung der theoretischen polarimetrischen Daten ein Verfahren des Typs Weidner-Modell für Netze mit asymmetrischen Profil nutzt.

10. Vorrichtung umfassend Mittel zur Durchführung des Verfahrens zum Messen durch Polarimetrie gemäß einem der Ansprüche 1-9, umfassend zudem eine Lichtquelle, zwei Polarimeter, welche jeweils einen Polarisator (11, 12), einen Analysator (13, 14) und einen Detektor umfassen, derart, dass:

- die azimutale Ausrichtung des Einen $\Phi_1$ sich von derjenigen des Anderen $\Phi_2$ unterscheidet,
- die auf dem Objekt durch das Eine und das Andere gemessenen Punkte überlagert sind.

11. Vorrichtung umfassend Mittel zur Durchführung des Verfahrens zum Messen durch Polarimetrie gemäß einem der Ansprüche 1-9, umfassend zudem eine Lichtquelle (21) zur Anregung eines Objekts (29), einen Polarisator (25), optische Mittel, welche geeignet sind, einen Lichtfluss zur Anregung, welcher durch die Quelle (21) erzeugt wird, zu dem Objekt (29) zu lenken, einen Analysator (30), einen Detektor (33), welcher geeignet ist, einen von dem Objekt (29) als Antwort auf den Fluss zur Anregung erzeugten Lichtfluss zur Messung zu empfangen, optische Mittel zur Messung, welche den Lichtfluss zur Messung, welcher durch das Objekt (29) erzeugt wurde, sammeln und zu dem Detektor (33) lenken, Mittel, welche es dem Detektor erlauben, unterschiedliche Messungen in Abhängigkeit von dem Azimutwinkel des Lichtflusses zur Anregung auf dem Objekt (29) und der Polarisation des reflektierten Lichtflusses zu erzeugen.

12. Vorrichtung zur Durchführung des Verfahrens zum Messen durch Polarimetrie gemäß Anspruch 11, **dadurch gekennzeichnet, dass** sie optische Mittel derart umfasst, dass das Lichtbündel zur Anregung auf Ebene des Objekts eine geringe räumliche Kohärenz enthalten zwischen 5 und 100 mal der Beugungsbegrenzung der Quelle (21) aufweist.

13. Vorrichtung zur Durchführung des Verfahrens zum Messen durch Polarimetrie gemäß Anspruch 12, **dadurch gekennzeichnet, dass** die Lichtquelle (21) eine gefilterte klassische Quelle ist.

14. Vorrichtung zur Durchführung des Verfahrens zum Messen durch Polarimetrie gemäß Anspruch 12, **dadurch gekennzeichnet, dass** die Lichtquelle (21) ein oder mehrere Laser mit unterschiedlichen Wellenlängen umfasst.

15. Vorrichtung zur Durchführung des Verfahrens zum Messen durch Polarimetrie gemäß einem der Ansprüche 11-14, **dadurch gekennzeichnet, dass** sie einen halbdurchlässigen Streifen (26) umfasst, welcher die Trennung des Lichtflusses zur Anregung bzw. zur Messung ermöglicht.

16. Vorrichtung zur Durchführung des Verfahrens zum Messen durch Polarimetrie gemäß einem der Ansprüche 11-15, **dadurch gekennzeichnet, dass** sie ein Objektiv mit großer numerischer Apertur umfasst, welches eine Fourier-Ebene aufweist, welches geeignet ist, von dem Fluss zur Anregung durchquert zu werden und zu bewirken, dass dieser auf dem Objekt (29) konvergiert, und zudem ausgelegt ist, den durch das Objekt (29) erzeugten Fluss zum Messen zu sammeln.

17. Vorrichtung zur Durchführung des Verfahrens zum Messen durch Polarimetrie gemäß einem der Ansprüche 11-16, **dadurch gekennzeichnet, dass** die optischen Mittel zur Anregung eine Maske in einer zu der Fourier-Ebene des Objektivs optisch konjugierten Ebene umfasst, welche geeignet ist, Lichtflüsse zur Anregung zu erzeugen, welche auf dem Objekt (29) unter unterschiedlichen Azimutwinkeln einfallen.

18. Vorrichtung zur Durchführung des Verfahrens zum Messen durch Polarimetrie gemäß einem der Ansprüche 11-17, **dadurch gekennzeichnet, dass** die optischen Mittel zum Messen eine Maske in einer zu der Fourier-Ebene des Objektivs optisch konjugierten Ebene umfassen, welche ausgelegt ist, die Lichtflüsse zum Messen, welche durch das Objekt (29) ausgestrahlt werden, unter verschiedenen Azimutwinkeln zu sammeln.

19. Vorrichtung zur Durchführung des Verfahrens zum Messen durch Polarimetrie gemäß einem der Ansprüche 1-18, **dadurch gekennzeichnet, dass** der Detektor ein Mehrpunktdetektor ist, welcher in einer zu der Fourier-Ebene des Objektivs optisch konjugierten Ebene angeordnet ist und welcher geeignet ist, die Lichtflüsse zum Messen, welche von dem Objekt (29) unter verschiedenen Azimutwinkeln ausgesendet werden, simultan zu messen.

20. Vorrichtung zur Durchführung des Verfahrens zum Messen durch Polarimetrie gemäß einem der Ansprüche 10-19, **dadurch gekennzeichnet, dass** der Polarisator (25) und der Analysator (30) Mittel zum Modulieren der Polarisation des einfallenden Bündels und Mittel zum Analysieren der Polarisation des reflektierten Bündels in einer Weise, die Gesamtheit der Mueller-Matrix des Netzes zu messen, umfassen.

21. Vorrichtung zur Durchführung des Verfahrens zum Messen durch Polarimetrie gemäß einem der Ansprüche 10-20, **dadurch gekennzeichnet, dass** sie Mittel zum Durchführen von polarimetrischen Messungen in Abhängigkeit von der Wellenlänge in einer Weise, spektroskopische Messungen zu erhalten, umfassen.

22. Vorrichtung zur Durchführung des Verfahrens zum Messen durch Polarimetrie gemäß Anspruch 21, **dadurch gekennzeichnet, dass** der Spektralbereich der Wellenlänge im nahen Ultraviolett liegt.

23. Vorrichtung zur Durchführung des Verfahrens zum Messen durch Polarimetrie gemäß Anspruch 21, **dadurch gekennzeichnet, dass** der Spektralbereich der Wellenlänge im Sichtbaren liegt.

FIGURE 1

FIGURE 2

FIGURE 3

FIGURE 4

FIGURE 5

Matrice de Müeller (VIS)    SE (UV-VIS)

FIGURE 6

FIGURE 7

**FIGURE 8**

$\phi=0°$

$\chi^2$

0.24
0.22
0.20
0.18
0.16
0.14
0.12
0.10
0.08
0.06
0.04
0.02
0

— 41

A (nm)

L (nm)

**FIGURE 9**

Moyenne
$\phi=30°,60°$

— 40

A (nm)

L (nm)

Déplacement à gauche
(L)

Pas de déplacement
(No)

Déplacement à droite
(R)

$\Lambda$

L

resist | D

45

resist

44

ARC

Substrat c-Si

43

$\Lambda$

L

resist

5H

0.5H

resist

H$_{ARC}$

ARC

Substrat c-Si

45

42

44

43

$\Lambda$

L

D | resist

resist

45

44

ARC

Substrat c-Si

43

## FIGURE 10

$M_{23}$  47  $\phi=0°$

$M_{23}$  48  $=30°$  47

$M_{23}$  48  $\phi=45°$  47

$M_{23}$  48  $\phi=60°$  47

$M_{23}$  48  $\phi=90°$  47

$M_{34}$  $\phi=0°$  30  45  60  90  49

Nombre d'onde (nm)

## FIGURE 11

18